# EUROPEAN PATENT APPLICATION

(11) **EP 3 588 588 A1**
(43) Date of publication of application: **01.01.2020**
(21) Application number: 18200092.7
(22) Date of filing: 12.10.2018
(51) Int. Cl.: H01L 31/18, H01L 31/02

(54) **DEVICE FOR ASSISTING A BUS BAR TO PASS THROUGH A HOLE AND SOLAR ASSEMBLY PRODUCTION LINE**

(30) Priority: 29.06.2018 CN 201821039018 U
(71) Applicant: Shandong Zibo Hanergy Thin Film Solar Cell Co., Ltd, 255086 Zibo, Shandong (CN)
(72) Inventor: ZHANG, Dong, Zibo, Shandong 255086 (CN)
(74) Representative: Modiano, Gabriella Diana

(57) **Abstract**

A device for assisting a bus bar to pass through a hole and a solar assembly production line are provided. The device for assisting a bus bar (2) to pass through a hole (3) includes a driving head arranged to pass through and extend out of a bus bar hole of a solar assembly (1) and then retract from the bus bar hole so as to drive the bus bar to pass through the bus bar hole; and a driving assembly, an output end of which is connected with the driving head, arranged to drive the driving head to move. The solar assembly production line includes the device for assisting a bus bar to pass through a hole.

## Description

This application claims the priority to Chinese patent application No. 201821039018.2 filed June 29, 2018, the entirety of which is hereby incorporated by reference.

### Technical Field

The present application relates to but is not limited to the technical field of solar power generation, in particular to a device for assisting a bus bar to pass through a hole and a solar assembly production line.

### Background

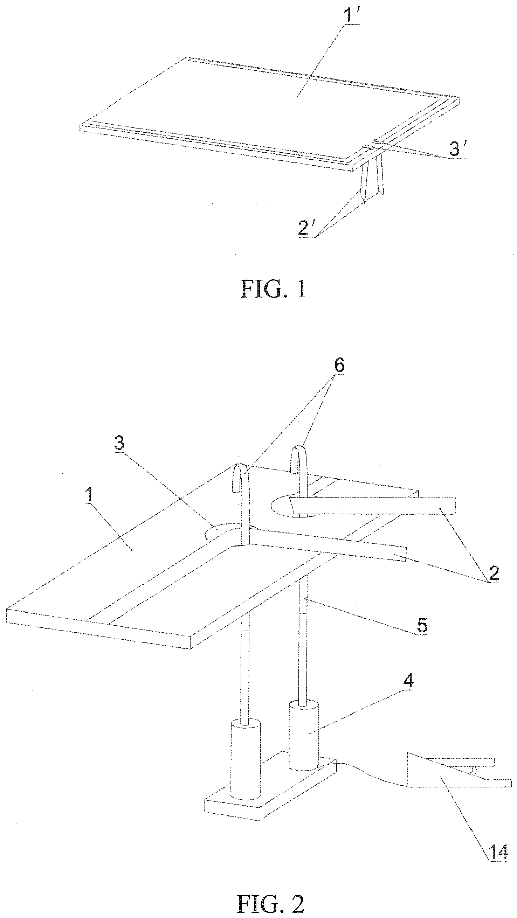

As shown in FIG. 1, a solar assembly I' is provided with bus bars 2' thereon in order to electrically connect a plurality of circuits. The solar assembly 1' is provided with bus bar holes 3'. One part of a bus bar 2' is attached to the upper side of the solar assembly 1' and the other part passes through the bus bar hole 3' provided in the solar assembly 1' so as to be located below the solar assembly 1'. A device for assisting a bus bar to pass through a hole can be used to assist the other part of the bus bar 2' described above to pass through the bus bar hole 3'. However, the efficiency of the device for assisting a bus bar to pass through a hole needs to be improved.

### Summary

The following is a summary of the subject matter described in detail herein. This summary is not intended to limit the protection scope of the claims.

An embodiment of the application provides a device for assisting a bus bar to pass through a hole including a driving head arranged to pass through and extend out of a bus bar hole of a solar assembly and then retract from the bus bar hole. When retracting from the bus bar hole, the driving head drives the bus bar to pass through the bus bar hole. The device for assisting a bus bar to pass through a hole also includes a driving assembly, an output end of which is connected with the driving head, and the driving assembly is arranged to drive the driving head to linearly reciprocate.

An embodiment of the application also provides a solar assembly production line which includes the device for assisting a bus bar to pass through a hole as described above.

Other aspects will become apparent after reading and understanding the brief description of the drawings and the embodiments of the present application.

### Brief Description of Drawings

The accompanying drawings are provided for further understanding the technical schemes of the embodiments of the present application. The accompanying drawings form a part of the specification, and together with the embodiments of the present application are served to explain the technical schemes of the embodiments of the present application. However, the drawings do not constitute a limitation on the technical schemes of the embodiments of the present application.
FIG. 1 is a schematic structural view of a solar assembly connected with a bus bar;
FIG. 2 is a schematic structural view of a device for assisting a bus bar to pass through a hole according to an embodiment of the present application;
FIG. 3 is a schematic structural view of a driving head in the form of a folded plate according to an embodiment of the present application;
FIG. 4 is a schematic structural view of a driving head according to another embodiment of the present application;
FIG. 5 is a structural schematic view of a device for assisting a bus bar to pass through a hole according to another embodiment of the present application;
FIG. 6 is a structural schematic view of a device for assisting a bus bar to pass through a hole according to yet another embodiment of the present application.

The reference signs in the drawings are as follows:
1' - solar assembly; 2' - bus bar; 3' - bus bar hole;
1 - solar assembly; 2 - bus bar; 3 - bus bar hole; 4 - lifting cylinder; 5 - flexible elongated handle; 6 - hook; 7 - folded plate; 8 - clamping jaw; 9 - receiving hole; 10 - clamping cylinder; 11 - motor; 12 - screw; 13 - nut; 14 - control assembly; 15 - flexible tube; 16 - vacuum pump; 17 - guide rod; 18 - slidable sleeve.

### Detailed Description

The technical scheme of the present application will be further explained with reference to the drawings and the embodiments. It is to be understood that the specific embodiments described herein are only for the purpose of explaining the present application and are not intended to limit the present application. In addition, for ease of description, only some of the parts relating to the present application are shown in the drawings.

A device for assisting a bus bar to pass through a hole includes a base and a trumpet-shaped bus bar hole arranged in the base. The trumpet-shaped bus bar hole is not a closed hole and has a notch on a side wall thereof. When the device for assisting a bus bar to pass through a hole is in use, the base is placed on the solar assembly 1' and the trumpet-shaped bus bar hole is arranged to be aligned with the bus bar hole 3' in the solar assembly 1'. The end with a larger diameter of the trumpet-shaped bus bar hole is arranged away from the solar assembly 1', so that an end of the bus bar 2' passes through from the end with a larger diameter of the trumpet-shaped bus bar hole, thereby the bus bar 2' can easily enter the trumpet-shaped bus bar hole. The bus bar 2' first penetrates into the trumpet-shaped bus bar hole, and the end with a smaller diameter of the trumpet-shaped bus bar hole clamps the end of the bus bar 2' which then penetrates into the bus bar hole 3' of the solar assembly 1', thereby passing the bus bar 2' through the hole is realized. Thereafter the bus bar 2' is removed through the notch on the side wall of the trumpet-shaped bus bar hole, and the device for assisting a bus bar to pass through a hole is taken away.

The device for assisting a bus bar to pass through a hole described above has the defects that the device for assisting a bus bar to pass through a hole needs to be repeatedly arranged and removed during use, and the bus bar needs to be passed through the hole manually. In addition, the bus bar 2' is long and the end thereof needs to be manually searched for and picked up so as to pass through the trumpet-shaped bus bar hole, thus the efficiency of passing through a hole is low.

An embodiment of the present application provides a device for assisting a bus bar to pass through a hole, which is mainly used for but not limited to passing a bus bar 2 through a bus bar hole 3 of a solar assembly 1 to improve the efficiency of passing through of the bus bar 2. The solar assembly 1 can be a copper indium gallium selenium (CIGS) double-glazed photovoltaic assembly or a crystalline silicon photovoltaic assembly or a building integrated photovoltaic (BIPV) double-glazed assembly.

As shown in FIG. 2, the device for assisting a bus bar to pass through a hole according to this embodiment includes a driving assembly and a driving head. The driving head is arranged to pass through and extend out of the bus bar hole 3 of the solar assembly 1 and then retract from the bus bar hole 3. The driving head can drive the bus bar 2 to pass through the bus bar hole 3 when retracting from the bus bar hole 3. The output end of the driving assembly is connected with the driving head, and the driving assembly is arranged to drive the driving head to linearly reciprocate.

A part of the bus bar 2 is attached to the upper side of the solar assembly 1 (only a part of the solar assembly 1 and the bus bar 2 thereon are shown in FIG. 2), and the other part of the bus bar 2, which is referred to as a free end portion of the bus bar 2 in this application, is freely arranged on the solar assembly 1. Since the joint point of the free end portion of the bus bar 2 and the portion of the bus bar 2 fixedly bonded to the solar assembly is located at a certain distance from the bus bar hole 3, the free end portion of the bus bar 2 is usually randomly located on the solar assembly 1. In this embodiment, the device for assisting a bus bar to pass through a hole is used to pass the free end portion of the bus bar 2 through the bus bar hole 3 and position the same below the solar assembly 1.

In addition, in actual operation, the solar assembly 1 can be transported to a predetermined position by a conveying device, and then the bus bar 2 can pass therethrough. The conveying device can be a conveying belt. The transport can be performed synchronously by two conveying belts, and the bus bar hole 3 of the solar assembly 1 is exposed without being blocked by the conveying belt. After the solar assembly 1 is transported to the predetermined position and located at the operation position where the bus bar passes through the hole, and when the bus bar hole 3 of the solar assembly 1 is located right above the driving head of the device for assisting a bus bar to pass through a hole of this embodiment, the device for assisting a bus bar to pass through a hole of this embodiment is initiated to perform the operation of passing the bus bar through the hole. After passing the bus bar through the bus bar hole of solar assembly 1, the conveying belt rotates to take the solar assembly 1 away from the operation position and transfer the next solar assembly 1 to the predetermined position.

The driving head of the device for assisting a bus bar to pass through a hole of this embodiment is arranged right below the bus bar hole 3, and the driving assembly drives the driving head to move upward. After the driving head passes through and extends out of the bus bar hole 3, only the free end portion of the bus bar 2 needs to be manually placed under the driving head, without having to manually pick up the end portion of the bus bar 2. Subsequently, the driving assembly drives the driving head to move downward and retract from the bus bar hole 3, and in the process of retracting from the bus bar hole 3, the driving head in turn drives the bus bar 2 to pass through the bus bar hole 3. By lifting and lowering the driving head, passing the bus bar 2 through the hole can be realized, so that the device for assisting a bus bar to pass through a hole does not need to be repeatedly moved. The device for assisting a bus bar to pass through a hole in this embodiment improves the efficiency of passing the bus bar 2 through the hole, thereby improving the production efficiency of the solar assembly 1 and reducing the labor intensity of workers.

In this embodiment, two sets of driving assemblies are provided, and each set of driving assembly is connected with a driving head. In other embodiments, the number of driving assemblies and driving heads can be increased or decreased according to the number of bus bar holes 3 in the solar assembly 1, and the number of sets of driving heads and driving assemblies can be set to be the same as the number of bus bar holes 3 in the solar assembly 1.

The driving assembly includes a lifting cylinder 4 and the upper end of the piston rod of the lifting cylinder 4 is connected with the driving head. In particular, the upper end of the piston rod of the lifting cylinder 4 can be connected with a flexible elongated handle 5 through which the driving head is connected with the piston rod of the lifting cylinder 4. The piston rod of the lifting cylinder 4 extends or contracts so as to drive the driving head to pass through or retract from the bus bar hole 3.

The connection between the upper end of the piston rod of the lifting cylinder 4 and the driving head, or between the flexible elongated handle 5 and the piston rod, or between the flexible elongated handle 5 and the driving head can be realized by screwing, snap-fitting, bonding and the like. However, the way of connection is not limited thereto.

The flexible elongated handle 5 can be omitted. After the piston rod of the lifting cylinder 4 is connected to the driving head, it is only necessary to ensure that the driving head can pass through and retract from the bus bar hole 3 during the stroke of the piston rod. In addition, the flexible elongated handle 5 may be made of a rigid material as long as the flexible elongated handle 5 can drive the driving head to smoothly pass through the bus bar hole 3.

The driving head of this embodiment includes a hooking member bended toward the moving direction of the driving head when retracting from the bus bar hole 3. The specific shape of the hooking member is not limited in this application as long as the bus bar 2 can be driven through the bus bar hole 3.

For example, as shown in FIG. 2, the hooking member may be a hook 6 bended toward the moving direction of the driving head when retracting from the bus bar hole 3, and the hook 6 is smoothly bended to prevent the bus bar 2 from being creased.

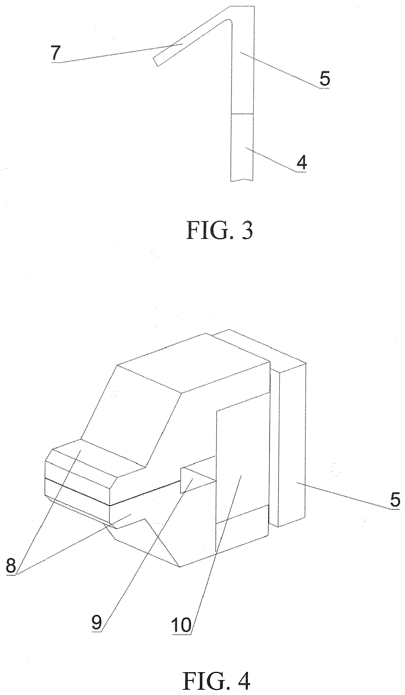

As shown in FIG. 3, the hooking member can be a folded plate 7 arranged at an acute angle with respect to the piston rod of the lifting cylinder 4, and the folded plate 7 is smoothly connected to the piston rod of the lifting cylinder 4. Alternatively, the folded plate 7 is smoothly connected with the piston rod of the lifting cylinder 4 through the flexible elongated handle 5.

The cross-sectional shape of the folded plate 7 may be but not limited to rectangular, circular, triangular, etc.

The hook 6, the folded plate 7, and the flexible elongated handle 5 may be made of a flexible material such as rubber or the like, so that due to the elasticity of the driving head, the bus bar 2 can be prevented from being pulled apart or peeled off from the weld point of the bus bar 2 and the solar assembly 1 when the bus bar 2 is subjected to a large pulling force.

As shown in FIG. 2, the surface of the driving head can also be provided with a smooth film, and a layer of adhesive tape having a smooth surface can be bonded onto the hook 6, the folded plate 7 and the upper end of the flexible elongated handle 5. The smooth film can also be made of other materials. The smooth film can effectively reduce the friction between the bus bar 2 and the driving head and prevent the bus bar 2 from being pulled apart.

In this embodiment, the device for assisting a bus bar to pass through a hole also includes a control assembly 14 electrically connected to the lifting cylinder 4. In particular, the control assembly 14 may be a pedal type switch or other type of switches, such as a button, as long as it can control the energizing of the lifting cylinder 4. The control assembly 14 is arranged to control the lifting cylinder 4 to perform the telescopic movement, that is, when the corresponding switch of the control assembly 14 is turned on, the lifting cylinder 4 starts to move telescopically, and when the corresponding switch of the control assembly 14 is turned off, the lifting cylinder 4 stops moving telescopically.

In this embodiment, the device for assisting a bus bar to pass through a hole may also include an operating holder and a positioning cylinder arranged on the operating holder. After the solar assembly 1 is transferred to a particular position by the conveying device, the positioning cylinder pushes the solar assembly 1 to a preset position so that the driving head is positioned right below the bus bar hole 3. In particular, two positioning cylinders can be provided, and the moving directions of the piston rods of the two positioning cylinders are perpendicular to each other, thereby realizing the positioning of the solar assembly 1 along two directions.

The steps of operating the device for assisting a bus bar to pass through a hole of this embodiment are as follows:
1) After the solar assembly 1 is transferred into position, the positioning cylinder is operated to push the solar assembly 1 to a preset position so that the driving head is right below the bus bar hole 3.
2) The lifting cylinder 4 drives the hook 6 or the folded plate 7 to pass through the bus bar hole 3 and be located above the solar assembly 1.
3) The bus bar 2 is manually wound around the piston rod of the lifting cylinder 4 or the flexible elongated handle 5, and the wound length is less than one turn so that the bus bar 2 will not be prevented from moving relative to the piston rod of the lifting cylinder 4 or the flexible elongated handle 5; or the bus bar 2 is manually placed over the bus bar hole 3 and right below the hook 6 or the folded plate 7.
4) The lifting cylinder 4 drives the hook 6 or the folded plate 7 to descend and retract from the bus bar hole 3. In this process, the hook 6 or the folded plate 7 can hook the bus bar 2 so that the free end portion of the bus bar 2 passes through the bus bar hole 3 and is located below solar assembly 1.

In this embodiment, when passing the bus bar 2 through the hole, it is only necessary to manually set the bus bar 2 at the bus bar hole 3 of the solar assembly 1 without manually picking up the end portion of the bus bar 2. In the process of driving the driving head to retract from the bus bar hole 3 by means of the driving assembly, the driving head drives the bus bar 2 to pass through the bus bar hole 3. By lifting and lowering the driving head, passing the bus bar 2 through the hole can be realized without repeatedly moving the device for assisting a bus bar to pass through a hole. The device for assisting a bus bar to pass through a hole according to the embodiment improves the efficiency of passing the bus bar 2 through the hole, thereby improving the production efficiency of the solar assembly and reducing the labor intensity of workers.

As shown in FIG. 4, in another embodiment of the present application, the device for assisting a bus bar to pass through a hole is substantially the same as that of the above embodiment, except that the driving head in this embodiment includes a clamping member that can be opened and closed, and a receiving hole 9 for the bus bar 2 to pass through is formed in the middle of the clamping member.

As an embodiment, the clamping member includes two clamping jaws 8, which are sequentially arranged opposite to each other along the movement direction of the driving head and are each provided with a through slot. In order to reduce friction between the bus bar 2 and the through slot, smooth films are arranged on both the side wall and the bottom wall of the through slot. In this embodiment, when the two clamping jaws 8 are tightly closed, the two through slots cooperate to form the receiving hole 9. The lengthwise direction of the receiving hole 9 is parallel to the horizontal direction, and the bus bar 2 is movable relative to the receiving hole 9.

In this embodiment, the two clamping jaws 8 can be in the form of a common clip, and are connected by a return spring. In operation, the two clamping jaws 8 can be manually separated to open the receiving hole 9, and after the bus bar 2 is inserted into the receiving hole 9, the two clamping jaws 8 are reset and tightly closed under the elastic force of the return spring to close the receiving hole 9.

In this embodiment, the driving head may further include a clamping cylinder 10. The cylinder body of the clamping cylinder 10 is connected to one of the clamping jaws 8 of the clamping member, and the output end of the clamping cylinder 10 is connected to the other clamping jaw 8 for driving the two clamping jaws 8 to be tightly closed or released. The cylinder body of the clamping cylinder 10 is also connected to the output end of the driving assembly directly or through the flexible elongated handle 5. The clamping cylinder 10 is electrically connected with the control assembly 14 to control the energizing of the clamping cylinder 10. The control assembly 14 is arranged to control the clamping cylinder 10 to perform a telescopic movement so as to drive the two clamping jaws 8 to be tightly closed or released.

In this embodiment, the lifting cylinder 4 drives the driving head to rise, and then the driving head passes through the bus bar hole 3 and extends out of the bus bar hole 3. At this point, the clamping cylinder 10 operates so that the two clamping jaws 8 of the driving head are in an opened state, then the middle portion of the bus bar 2 is placed in the through slot of one of the clamping jaws 8, thereafter the two clamping jaws 8 are tightly closed. The lifting cylinder 4 drives the driving head to move downward, and the free end portion of the bus bar 2 is driven to pass through the bus bar hole 3 so as to be positioned below the solar assembly 1.

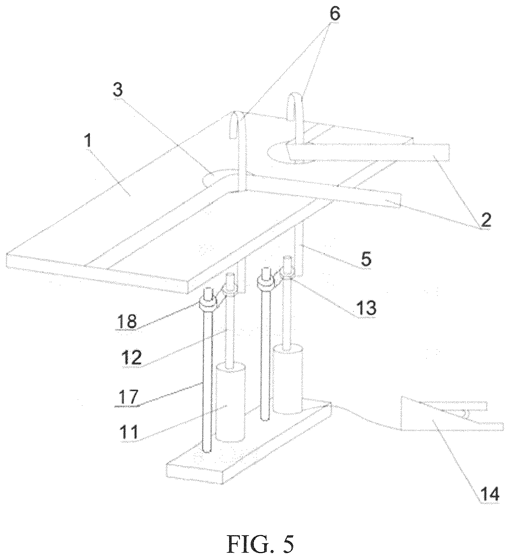

In another embodiment of the present application as shown in FIG. 5, the main difference between the device for assisting a bus bar to pass through a hole in this embodiment and that in the above described embodiment is that the driving assembly of the device for assisting a bus bar to pass through a hole of this embodiment includes a motor 11, a screw 12 and a nut 13.

The screw 12 is connected to the output shaft of the motor 11 which drives the screw 12 to rotate around the axis thereof. The nut 13 is threadedly connected with the screw 12 and can move along the axial direction of the screw 12. The driving head can be connected to the nut 13 directly or through the flexible elongated handle 5. The motor 11 drives the nut 13 and the driving head to move up and down.

The screw 12 and the nut 13 of this embodiment realize a spiral transmission in such a manner that the screw rotates and the nut moves linearly. The movement of the nut 13 along the axial direction of the screw 12 can be realized by using a guide mechanism. The guide mechanism includes a guide rod 17 and a slidable sleeve 18 slidably arranged on the guide rod 17. The slidable sleeve 18 is fixedly connected with the nut 13, and the guide rod 17 is fixed and kept still.

The motor 11 is electrically connected to the control assembly 14 which controls the energizing of the motor 11. The control assembly 14 is configured to control the screw 12 to start and stop rotating.

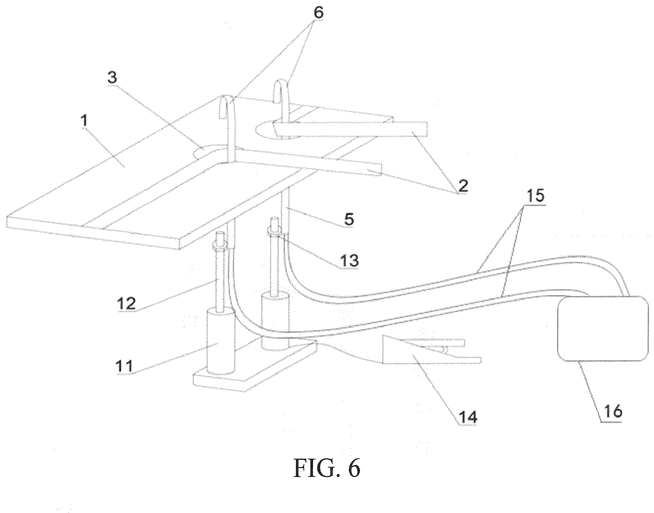

In another embodiment of the present application as shown in FIG. 6, the device for assisting a bus bar to pass through a hole further includes a vacuumizing device. A passage communicated with the vacuumizing device is arranged inside the driving head, and a suction port (not shown) communicated with the passage is arranged at the end of the driving head which passes through and extends out of the bus bar hole 3.

In this embodiment, the vacuumizing device includes a vacuum pump 16 and a flexible tube 15 connected to the vacuum pump 16 and communicated with the passage inside the driving head. When the vacuum pump 16 is in operation, negative pressure is created in the passage inside the driving head, so that the bus bar 2 can be adsorbed to the suction port of the driving head. Thus, when retracting from the bus bar hole 3 of the solar assembly 1, the driving head can drive the bus bar 2 to pass through the bus bar hole 3.

In this embodiment, the shape of the driving head is not limited, and the suction port is provided in the portion of the driving head protruding from the bus bar hole 3. The driving head may be a hook, and the suction port may be provided at the bended portion of the hook, or at a position close to the bus bar hole 3 after the hook extends out of the bus bar hole 3. The driving head may also be of a hollow tubular structure, with a tube opening at one end thereof communicated with the flexible tube 15 of the vacuumizing device and a tube opening at the other end serving as the suction port. The tube body is connected with the driving assembly.

In this embodiment, the vacuum pump 16 may be electrically connected to the control assembly 14, and the control assembly 14 may control the vacuum pump 16 to be switched on or off.

An embodiment of the application also provides a solar assembly production line, which includes the device for assisting a bus bar to pass through a hole according to any of the above embodiments. As the assisting device improves the efficiency of passing the bus bar through the hole, the production efficiency of the solar assembly production line in this embodiment is improved and the labor intensity of workers is reduced.

In the description of the embodiments of this application, the orientations or positions indicated by the terms "upper", "lower", "left", "right", "top", "inner", "outer", "axial direction", "corners" and the like are determined based on the orientations or positions shown in the drawings, and merely for purpose of simplifying the description of the embodiments of this application. Such terms do not intend to indicate or imply that the structure referred to has a particular orientation or is constructed and operated in a particular orientation, and therefore cannot be construed as limiting the application.

In the description of the embodiments of this application, the terms "connect", "fixedly connect", "mount", "install" should be broadly interpreted unless otherwise explicitly specified or defined. For example, such terms may be interpreted as fixed connecting, detachable connecting, or connecting into one piece. The terms "mount", "connect" and "fixedly connect" can be interpreted as connecting directly or indirectly through an intermediate medium, and can be interpreted as the internal communication between two elements. For those ordinary skilled in the art, the specific meaning of the above terms in the embodiments of this application can be interpreted according to the specific context.

Obviously, the above-mentioned embodiments of the present application are only examples for clearly illustrating the present application and are not intended to limit the embodiments of the present application. For those of ordinary skill in the art to which this application pertains, other forms of variations or modifications may be made on the basis of the above described embodiments. The embodiments herein are not exhaustive. Any modifications, equivalent substitutions, improvements and the like made without departing from the spirit and principle of the present application are fallen within the protection scope of the claims of the present application.

## Claims

1. A device for assisting a bus bar to pass through a hole, comprising:
a driving head arranged to pass through and extend out of a bus bar hole (3) of a solar assembly (1) and then retract from the bus bar hole (3), wherein when retracting from the bus bar hole (3), the driving head drives a bus bar (2) to pass through the bus bar hole (3); and
a driving assembly, an output end of which being connected with the driving head, wherein the driving assembly is arranged to drive the driving head to linearly reciprocate.

2. The device for assisting a bus bar to pass through a hole according to claim 1, wherein the driving head comprises a hook (6) bended toward a moving direction of the driving head when retracting from the bus bar hole (3).

3. The device for assisting a bus bar to pass through a hole according to claim 1, wherein the driving head comprises a folded plate (7) arranged at an acute angle with respect to the output end of the driving assembly.

4. The device for assisting a bus bar to pass through a hole according to claim 1, wherein the driving head is made of a flexible material.

5. The device for assisting a bus bar to pass through a hole according to claim 1, wherein the driving head comprises a clamping member capable of being opened and closed, and a receiving hole (9) for the bus bar (2) to pass through is formed in the middle of the clamping member.

6. The device for assisting a bus bar to pass through a hole according to claim 5, wherein
the clamping member comprises two clamping jaws (8), each clamping jaw (8) is provided with a through slot, and the two through slots cooperate to form the receiving hole (9);
the driving head further comprises a clamping cylinder (10) connected with the two clamping jaws (8) and arranged to drive the two clamping jaws (8) to be tightly closed or released.

7. The device for assisting a bus bar to pass through a hole according to claim 5, wherein a smooth film is provided on a wall of the receiving hole (9).

8. The device for assisting a bus bar to pass through a hole according to claim 1, wherein the driving assembly comprises a lifting cylinder (4), and a piston rod of the lifting cylinder (4) is connected with the driving head.

9. The device for assisting a bus bar to pass through a hole according to claim 1, wherein the driving assembly comprises:
a motor (11);
a screw (12) connected to an output shaft of the motor (11) and arranged to rotate around the axis thereof when being driven by the motor (11); and
a nut (13) configured to be threadedly connected to the screw (12) and to be connected to the driving head, and configured to move along an axial direction of the screw (12) when the screw (12) is rotated.

10. The device for assisting a bus bar to pass through a hole according to claim 1, wherein the device for assisting a bus bar to pass through a hole further comprises a control assembly (14) electrically connected to one or more of the driving assembly and the driving head.

11. The device for assisting a bus bar to pass through a hole according to claim 1, wherein the device for assisting a bus bar to pass through a hole further comprises an operating holder and a positioning cylinder, wherein the positioning cylinder is arranged on the operating holder and is arranged to push the solar assembly (1) to a preset position.

12. The device for assisting a bus bar to pass through a hole according to claim 1, wherein the device for assisting a bus bar to pass through a hole further comprises a flexible elongated handle (5), and the output end of the driving assembly is connected with the driving head through the flexible elongated handle (5).

13. The device for assisting a bus bar to pass through a hole according to claim 1, wherein a smooth film is provided on a surface of the driving head.

14. The device for assisting a bus bar to pass through a hole according to claim 1, wherein the device for assisting a bus bar to pass through a hole further comprises a vacuumizing device, a passage communicated with the vacuumizing device is provided inside the driving head, and a suction port communicated with the passage is arranged at the end of the driving head passing through and extending out of the bus bar hole (3).

15. A solar assembly production line comprising the device for assisting a bus bar to pass through a hole according to any one of claims 1 to 14.
